Europäisches Patentamt

European Patent Office

Office européen des brevets

(19)

(11) Publication number: **0 259 158**
**A2**

# (12) EUROPEAN PATENT APPLICATION

(21) Application number: **87307778.8**

(22) Date of filing: **03.09.87**

(51) Int. Cl.⁴: **G 11 C 11/00**

(30) Priority: **05.09.86 JP 209319/86**

(43) Date of publication of application:
**09.03.88 Bulletin 88/10**

(84) Designated Contracting States: **DE GB**

(71) Applicant: **AGENCY OF INDUSTRIAL SCIENCE & TECHNOLOGY MINISTRY OF INTERNATIONAL TRADE & INDUSTRY**
**3-1 Kasumigaseki 1-chome Chiyoda-ku Tokyo (JP)**

**SEIKO INSTRUMENTS INC.**
**31-1, Kameido 6-chome Koto-ku**
**Tokyo 136 (JP)**

(72) Inventor: **Hayashi, Yutaka Agency Ind. Science and Technology**
**Min. Int. Trade Ind. Ele. Techn. Lab. 1-4, Umezono 1-chome, Sakuramura Niihari-gun Ibaragi (JP)**

**Kamiya, Masaaki**
**SEIKO INSTRUMENTS INC. 31-1, Kameido 6-chome Koto-ku Tokyo (JP)**

**Kojima, Yoshikazu**
**SEIKO INSTRUMENTS INC. 31-1, Kameido 6-chome Koto-ku Tokyo (JP)**

(74) Representative: **Caro, William Egerton et al**
**J. MILLER & CO. Lincoln House 296-302 High Holborn London WC1V 7JH (GB)**

(54) Semiconductor non-volatile random access memory.

(57) A semiconductor non-volatile random access memory comprises an insulating film (12) disposed on a semiconductor substrate (100) of a first conductivity type. Charge storing means (13) are provided in the insulating film. A first insulated gate electrode (15) is electrically coupled to the charge storing means (13) and controls electric potential in a region (11) in the surface of the substrate under the charge storing means. A second insulated gate electrode (35) is provided to form a channel (31) in a region of the substrate (100) adjacent to the region (11) under the charge storing means (13). A read/write region (40) is of a second conductivity type opposite the first conductivity type provided adjacent to the region where the channel (31) is formed. In operation, volatile information in the form of electric potential or electric charge is stored when power is supplied to the region (11) in the substrate under the charge storing means (13), and information is transferred to the charge storing means (13) to store the information therein in non-volatile form before a power supply is perfectly turned off.

*Fig.1.*

EP 0 259 158 A2

Bundesdruckerei Berlin

**Description**

## SEMICONDUCTOR NON-VOLATILE RANDOM ACCESS MEMORY

This invention relates to semiconductor non-volatile random access memories (NVRAM) which are capable of reading and writing operations when power is supplied and capable of storing information in a non-volatile form when power is not supplied.

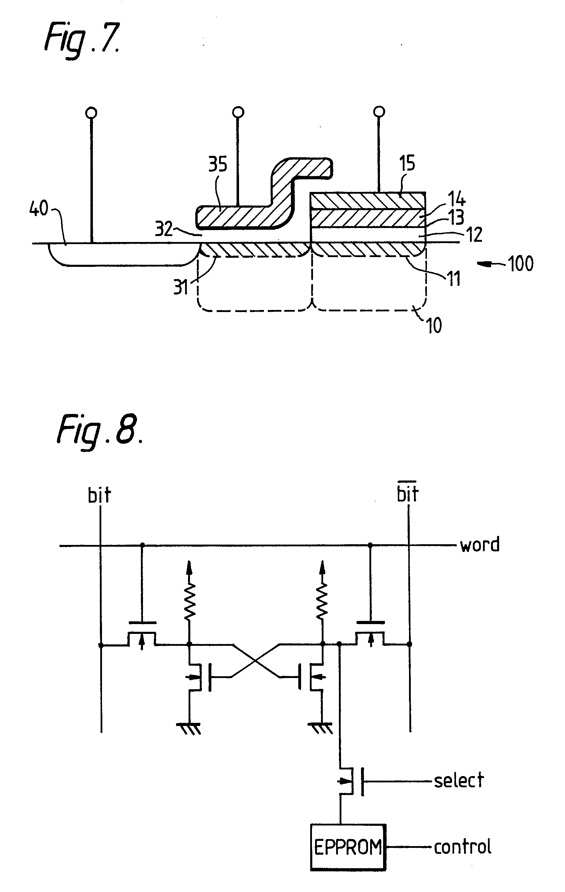

As shown in Figure 8, a conventional NVRAM has a flip-flop type static RAM (SRAM) having 4 to 6 transistors which is connected to an electrically erasable programmable ROM through a switching transistor. When power is supplied, the SRAM stores information in a volatile form. The information is transferred, immediately before the power supply is turned off, through the switching transistor to an EEPROM where the information is stored in non-volatile form. Because of this feature, a unit cell of a conventional NVRAM requires 6 to 9 transistors. If many transistors are required in a unit cell, the cell area becomes large, and this causes problems with respect to high-integration of a cell. There is also a problem in that the speed of operation cannot be increased because of potential losses and propagation delays of each transistor accumulate.

The present invention seeks to reduce the number of components of an NVRAM by using the structure operating as EEPROM as a part of the components of RAM function during stable operation when power is supplied or by using it as a transfer gate.

According to one aspect of the present invention there is provided a semiconductor non-volatile random access memory characterised by comprising an insulating film disposed on a semiconductor substrate of a first conductivity type, charge storing means provided in said insulating film, a first insulated gate electrode electrically coupled to said charge storing means and controlling electric potential in a region in the surface of said substrate under said charge storing means, a second insulated gate electrode provided to form a channel in a region in said substrate adjacent to said region under said charge storing means and a read/write region of a second conductivity type opposite said first conductivity type provided adjacent to the region where the channel is formed, thereby, in operation, storing volatile information in the form of electric potential or electric charge when power is supplied to the region in said substrate under said charge storing means, and transferring said information to said charge storing means to store said information therein in non-volatile form before a power supply is perfectly cut off.

The semiconductor non-volatile RAM may include a third insulated gate electrode provided over a region in the surface of said substrate adjacent to the region under said charge storing means, thereby, in operation, storing volatile information in the form of electric potential or electric charge when power is supplied to the region of said substrate under said third insulated gate electrode and transferring said information through the top surface region of said substrate under said charge storing means to said charge storing means to store the information therein in non-volatile form before the power supply is perfectly cut off.

According to another aspect of the present invention there is provided a semiconductor non-volatile random access memory characterised by comprising an insulating film formed on a first semiconductor region, a charge storing means provided in said insulating film, a first insulated gate electrode electrically coupled to said charge storing means and controlling electric potential in the surface of said first semiconductor region, a second semiconductor region in electrical contact with said first semiconductor region, a second insulated gate electrode provided to form a channel in said second semiconductor region and a read/write region in electrical contact with said second semiconductor region, thereby, in operation, storing volatile information in the form of electric charge or electric potential in said first semiconductor region and transferring said information stored in said first semiconductor region to said charge storing means to store said information therein in non-volatile form before a power supply is perfectly turned off.

The semiconductor non-volatile RAM may include a third semiconductor region in electrical contact with said first semiconductor region, a third insulated gate electrode for controlling electric potential of said third semiconductor region, thereby, in operation, storing volatile information in the form of electric charge or electric potential in said third semiconductor region and transferring said information stored in said third semiconductor region through the surface of said first semiconductor region to said charge storing means to store said information therein in a non-volatile form before the power supply is perfectly turned off.

According to a further aspect of the present invention there is provided a semiconductor non-volatile random access memory characterised by comprising a first semiconductor region, a first insulating film(s) on said first semiconductor region, a charge storing means provided in said insulating film(s), a first insulated gate electrode electrically coupled to said charge storing means and controlling the electric potential in said first semiconductor region under said charge storing means, thereby, in operation, storing volatile information in the form of electric charge or electric potential in said first semiconductor region, and converting said volatile information into non-volatile form by applying a voltage to said first insulated gate electrode before the power supply is perfectly turned off.

This semiconductor non-volatile RAM may include a further semiconductor region adjacent to said first semiconductor region, thereby, in operation, storing said volatile information in the form of electric charge or electric potential in said further semiconductor region and converting said volatile information into a non-volatile form through said first semiconductor region by applying voltage to said first insulated gate electrode before the power supply is perfectly turned off.

Additionally or alternatively the semiconductor non-volatile RAM may include a second semi conductor region electrically connected to said first semiconductor region, a second insulated gate electrode controlling a channel formed in said second semiconductor region, a read/write region being electrically connected to said second semiconductor region.

Said charge storing means may be a floating gate. Alternatively the charge storing means may be formed by MNOS (Metal-Nitride-Oxide-Semiconductor) or MONOS (Metal-Oxide-Nitride-Oxide-Semiconductor).

The invention is illustrated, merely by way of example, in the accompanying drawings, in which:-

Figure 1 is a sectional view of a first embodiment of an NVRAM according to the present invention;

Figure 2 is a sectional view of a second embodiment of an NVRAM according to the present invention wherein an insulated gate electrode and a semiconductor region are additionally provided to the embodiment shown in Figure 1;

Figure 3 is a sectional view of a third embodiment of an NVRAM according to the present invention;

Figure 4 is a sectional view of a fourth embodiment of an NVRAM according to the present invention wherein each semiconductor region is connected with semiconductor regions of second conductivity type opposite a first conductivity type of a substrate;

Figure 5 is a sectional view of a fifth embodiment of an NVRAM according to the present invention wherein a read/write region of a second conductivity type is provided in a substrate of a first conductivity type opposite the second conductivity type;

Figures 6 and 7 show different charge storing means for an NVRAM according to the present invention; and

Figure 8 is a schematic view of a prior art NVRAM.

Throughout the drawings like parts have been designated by the same reference numerals.

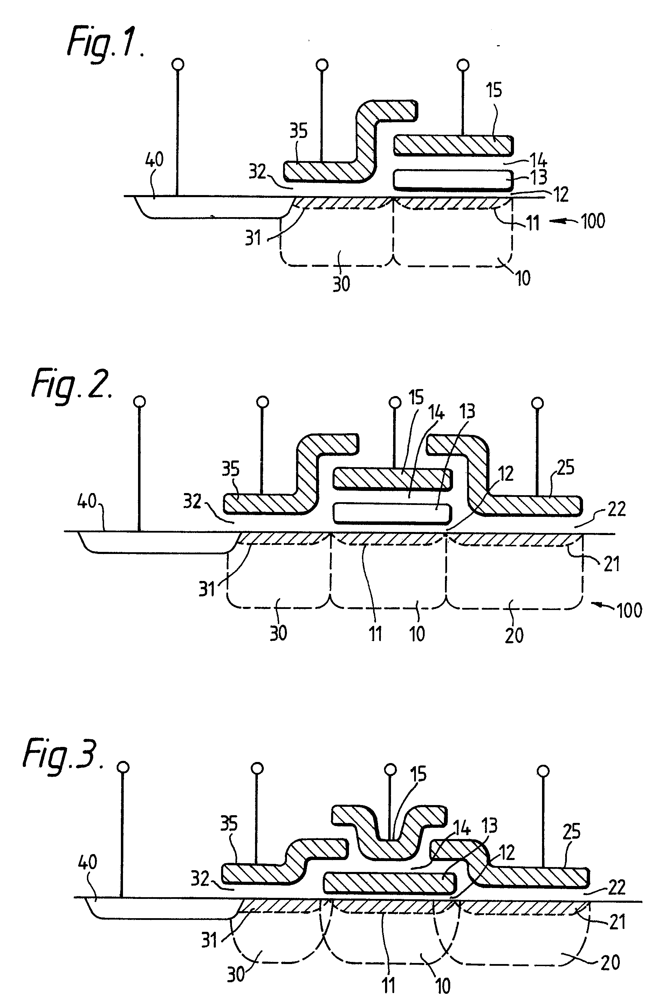

Figure 1 shows one embodiment of an NVRAM according to the present invention. Reference numeral 100 designates a semiconductor substrate or a semiconductor region formed on a semiconductor substrate surface or a semiconductor region formed on an insulating substrate. Electric charge is induced or electric potential is controlled in a region 11 of a first semiconductor region 10 according to the electric potential of a first insulated electrode 15. A thin insulating film 12, capable of transferring carriers under the influence of a strong electric field, is provided on the surface of the first semiconductor region 10, and further, adjacent to the insulating film, is provided an electric charge storing means 13 composed of a conductivity material or an insulating film having smaller energy gap than that of the insulating film 12 or a strong dielectric film. For example, a floating gate which is formed by a multi-layer polysilicon technique or a semiconductor trap between different insulating films, e.g., MNOS (Metal-Nitride-Oxide-Semiconductor) can be used as the electric charge storing means 13.

The insulated gate electrode 15 is provided either above the electric charge storing means with an insulating film 14 therebetween in the case where the electric charge storing means is of conductive material or directly on the electric charge storing means in the case where the electric charge storing means is an insulating film. In the case where the electric charge storing means 13 is of conductive material, the insulated gate electrode 15 is not necessarily provided directly above the first semiconductor region 10. A region 30 is a second semiconductor region where a channel 31 is turned on in the surface thereof by a second insulated gate electrode 35 provided over an insulating film 32. A read/write region 40 is provided next to the semiconductor region 30. The read/write region 40 is rectifying-junctioned with the second semiconductor region 30. The first semiconductor region 10 may be directly in contact with or may be in electrical communication through a fourth semiconductor region or a fourth channel (not shown) with the second semiconductor region 30. The aim of the present invention is accomplished if the first semiconductor region and the channel-forming second semiconductor region are electrically in contact.

The following explains the operation of the NVRAM shown in Figure 1. The operation of electric charge and potential is explained here by assuming the channel as an n-channel. In order to write information into this memory cell, an electric potential of a few volts or nearly zero volts is applied to the read/write region 40 which corresponds to the information "1" or "0", and an electric potential of a few volts is applied to the second insulated gate electrode 35 and the first insulated gate electrode 15. Under this condition, the channel 31 is turned on with electrons in the surface of the second semiconductor region 30. Electrons are induced (an electric charge of nearly zero volts is written) in the surface of the first semiconductor region 10 when the electric potential applied to the read/write region 40 is nearly zero volts, while the surface of the first semiconductor region 10 has an electric potential of a few volts when the electric potential applied to the read/write region 40 is a few volts. When the electric potential at the second insulated gate electrode 32 is reduced to nearly zero volts to turn off the channel, the information is stored in the surface of the first semiconductor region 10. But when the voltage applied to the first insulated gate electrode 15 is turned off, or after an hour or more, the information is not maintained therein. Therefore, if the information is desired to be maintained, a refreshing operation, such as carried out for a dynamic RAM, can be executed as long as power is supplied. When power is not supplied, this refreshing operation cannot be executed. In such a case, a high voltage of 10 to 20 volts is applied to the first insulated gate electrode 15 immediately before the power supply is perfectly turned off, thereby injecting a carrier electric charge from the surface of the first semiconductor region 10 into the electric charge storing means 13. When the surface of the first semiconductor region 10 has an electron electric charge or has a low surface potential, a strong electric field occurs in the insulating film 12 causing an electric charge injection into the charge storing means which is then electrified towards negative charge. While, the first semiconductor region 10 has a high surface potential, electric charge injection scarcely occurs by the foregoing operation because the electric field in the insulating film 12 is weak. In this manner, information can be stored even after the power supply is turned off. When the power supply is turned on again, and the stored information is read out from the memory cell (recalling operation), an electric potential of nearly zero volts is applied to the read/write region 40 and an electric potential of a few volts is applied to the second insulated gate electrode 35 and the first insulated gate electrode 15. Under this condition, if the electric charge storing means 13 stores a negative electric charge, it is difficult to induce an electric charge on the surface of the first semiconductor region 10. While, when a charge stored in the electric charge storing means (13) is a few volts, an electric charge is induced in the surface of the first semiconductor region 10. In this manner, the information can be discriminated. However, the electric charge induced in the surface of the first semiconductor region 10, namely information "1" or "0" is inverted in comparison with the electric charge immediately before the voltage of the power supply was turned off. Therefore, it is necessary to invert such information. This operation is easily carried out by adding an inversion circuit outside of the NVRAM to a detecting circuit and a writing circuit which are installed as peripheral circuits of a memory cell array.

In the embodiment shown in Figure 1, the surface of the first semiconductor region 10 has a limited capacity for storing electric charge, but the electric charge storing means 13 has a large electric charge capturing efficiency. Because of this, the electric charge storing means should preferably be composed of a conductive material rather than an insulating film having a small energy gap. Polycrystalline silicon thin film is typical of such material. As will be appreciated the NVRAM of Figure 1 can be realised with an area of one or two transistors and, therefore, can be insulated in an extremely small area compared to a prior art NVRAM of Figure 8.

Figure 2 shows a second embodiment of an NVRAM according to the present invention showing a modification of the NVRAM of Figure 1. A third semiconductor region 20 is electrically in contact with the first semiconductor region 10. The third semiconductor region 20 stores information according to the magnitude of the electric potential in the surface thereof, the magnitude of space-charge formed therein, or the magnitude of electric potential in a region 21 which forms a PN junction. In order to store information in a non-volatile form before the power supply is perfectly turned off, the second insulated gate electrode 35 is kept at nearly zero volts. A third insulated gate electrode 25 is provided with a bias voltage close to the bias voltage applied when the volatile information is stored therein and the first insulated gate electrode 15 is provided with a voltage of 10 to 20 volts. Under this condition, information is is transferred from the surface of the third semiconductor region 20 to the electric charge storing means 13 and stored therein. Namely, in the case where there is an electric charge in the surface of the third semiconductor region 20 or an electric potential in the region 21 forming a PN junction is close to zero volts, a strong electric field occurs between the electric charge storing means 13 and the surface of the first semiconductor region 10 when a high voltage is applied to the first insulated gate electrode 15. Consequently, an injection of electric charge occurs and the electric charge storing means is electrified towards negative charge. While, in the case where the region 21 of the semiconductor region 20 does not have electric charge or has a high electric potential, an electric field occurring in the insulating film 12 is weak, and therefore injection of an electric charge hardly occurs. Once the information is stored in this manner, the information is stored in non-volatile form even after the power supply is perfectly cut off.

In the case of the embodiment shown in Figure 2, the area of the third semiconductor region 20 governing the volatile memory can be designed larger than that of the first semiconductor region 10 under the charge storing means 13, which gives more energy storage capacity to the semiconductor region surface. This allows the charge storing means to have greater storage capacity, consequently giving the NVRAM better characteristics in writing and rewriting capabilities. Further, if the electric charge storing means is of the same type as that shown in Figure 1, its density of storage capacitance is larger and therefore the detecting margin is wider, when recalling information after electric supply is turned on again.

For recalling operation, the following 2-stage operation is carried out. First the read/write region 40 is kept at an electric potential of nearly zero volts, the second insulated gate electrode 35 and the third insulated gate 25 are biased with a voltage $V_R$ of a few volts to turn on channels 31,21, and the first insulated gate electrode with a voltage ($V_R + \Delta V$). $\Delta V$ is a voltage whereby the channel 11 in the surface of the first semiconductor region is turned on even in the case where a negative charge is stored in the electric charge storing means 13, by compensating for such negative charge. By this operation, electrons or a low electric potential is transferred from the read/write region 40 to the surface of the third semiconductor region 20 through the channels 31,11. Then, as the second stage, the electric potential at the first insulated gate electrode 15 is lowered by more than $\Delta V$, and a bias voltage of a few volts is applied to the read/write region 40. Under this condition, if the electric charge storing means stores a negative charge, the channel 11 is not turned on in the surface of the first semiconductor region 10 and consequently there is no transfer of electric charge from the surface of the third semiconductor region 20, thus, the low electric potential or the electric charge is kept trapped in the surface of the third semiconductor region under the insulated gate electrode 25. On the other hand, if a negative charge is not stored in the electric charge storing means 13, the channel 11 is turned on in the surface of the first semiconductor region 10 under the aforementioned condition, and the low electric potential or the electric charge in the surface of the third semiconductor region is transferred to the read/write region 40. As described hereinabove, the magnitude of inputted (write) information, i.e. information "1" or "0", corresponds to the magnitude of recalled (read) information, therefore an inversion circuit such as required for the first embodiment of NVRAM of Figure 1 is not required. At random access memory operation, the first insulated gate electrode is used as a transfer gate. By arranging an array in such a manner that a transistor having the second insulated gate electrode 35 connected to an X line and a transistor having the first insulated gate electrode 15 to a Y line, the NVRAM according to the present invention can be used as an (X,Y) addressable transistor.

In the abovementioned two embodiments of NVRAMs according to the present invention, after a recalling operation and before restarting a random access memory operation, it is required that the negative electric charge stored in the electric charge storing means shall be discharged by applying a negative voltage of -10 to -20 volts to the first insulated gate electrode 15. In the embodiment of NVRAM shown in Figure 2, if the insulating film 22 is thin to the extent that a Fowler-Nordheim tunneling current or direct tunneling current flows therein a small size NVRAM having a static memory which does not require a refreshing operation can be realised together with the third semiconductor region 20 or the channel region 21 if it exists, and the third insulated gate electrode 25. The advantage of this structure is that, as described hereinabove, an inversion circuit is not required outside of this NVRAM.

Figure 3 is a third embodiment of an NVRAM according to the present invention, wherein a triple-layer polysilicon technique is employed on the NVRAM of Figure 2.

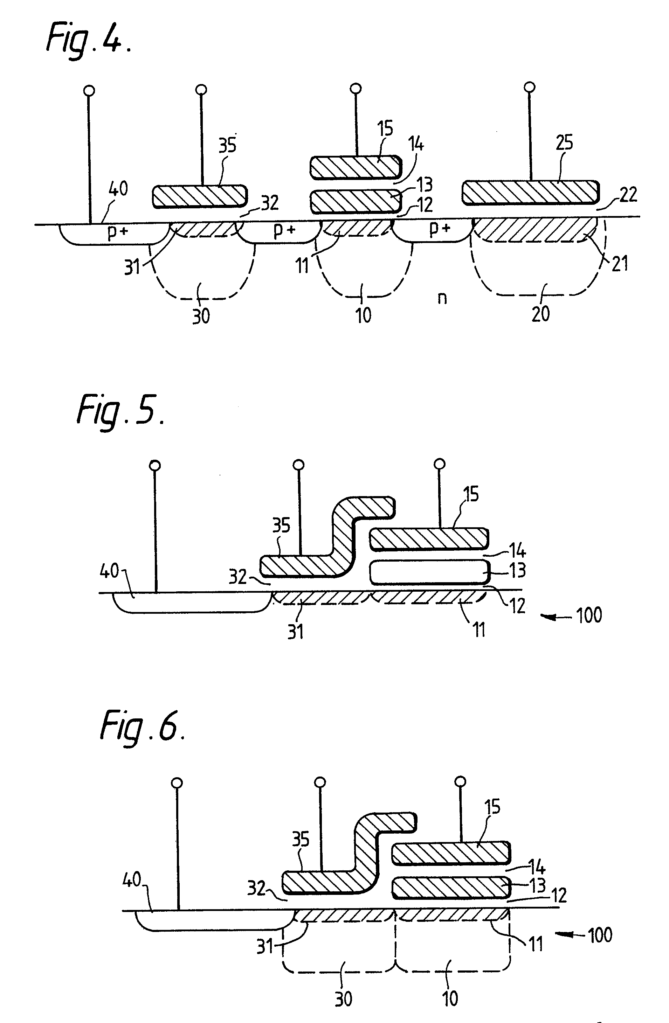

Figure 4 is a fourth embodiment of NVRAM according to the present invention wherein a double-layer polysilicon technique is employed on the NVRAM of Figure 2. In this case, each region is electrically contacted by a P+ layer or an N+ layer, which results in a larger cell area. However, the manufacturing process is simplified.

Figure 5 is a fifth embodiment, wherein neither the first semiconductor region nor the second semiconductor region is provided in the substrate of a first conductivity type. The read/write region 40 is of a second conductivity type opposite the first conductivity type. This structure has the same function as described with reference to the embodiment of NVRAM shown in Figure 1. Although it is not shown in the drawings, it is also possible to provide an integrated well type semiconductor region in the substrate instead of providing separated semiconductor regions such as described above.

Figure 6 shows an embodiment of NVRAM according to the present invention and similar to Figure 1 in which a floating gate is used as the charge storing means 13.

Figure 7 shows an embodiment of NVRAM according to the present invention and similar to Figure 1 in which an MNOS (Metal-Nitride-Oxide-Semiconductor) is used as the charge storing means 13 where the insulating film 14 of $Si_3N_4$ is provided over the insulating film 12 of $SiO_2$.

As described above, according to the present invention a unit cell of an NVRAM can be composed of 1 to 2 transistors in a limited area by electrically coupling a region governing volatile memory to a region governing non-volatile memory without using switching elements. Therefore, cell area becomes extremely small and consequently a high density integrated NVRAM can be realised.

## Claims

1. A semiconductor non-volatile random access memory characterised by comprising an insulating film (12) disposed on a semiconductor substrate (100) of a first conductivity type, charge storing means (13) provided in said insulating film, a first insulated gate electrode (15) electrically coupled to said charge storing means (13) and controlling electric potential in a region (11) in the surface of said substrate under said charge storing means, a second insulated gate electrode (35) provided to form a channel (31) in a region in said substrate (100) adjacent to said region (11) under said charge storing means (13) and a read/write region (40) of a second conductivity type opposite said first conductivity type provided adjacent to the region where the channel (31) is formed, thereby, in operation, storing volatile information in the form of electric potential or electric charge when power is supplied to the region (11) in said substrate under said charge storing means (13), and transferring said information to said charge storing means (13) to store said information therein in non-volatile form before a power supply is perfectly turned off.

2. A semiconductor non-volatile random access memory as claimed in claim 1 characterised by a third insulated gate electrode (25) provided over a region (21) in the surface of said substrate (100) adjacent to the region under said charge storing means (13), thereby, in operation, storing volatile information in the form of electric potential or electric charge when power is supplied to the region (21) of said substrate under said third insulated gate electrode (25) and transferring said information through the top surface region of said substrate under said charge storing means (13) to said charge storing means to store the information therein in non-volatile form before the power supply is perfectly turned off.

3. A semiconductor non-volatile random access memory characterised by comprising an insulating film (12) formed on a first semiconductor region (10), a charge storing means (13) provided in said insulating film (12), a first insulated gate electrode (15) electrically coupled to said charge storing means (13) and controlling electric potential in the surface of said first semiconductor region (10), a second semiconductor region (30) in electrical contact with said first semiconductor region (10), a second insulated gate electrode (35) provided to form a channel (31) in said second semiconductor region and a read/write region (40) in electrical contact with said second semiconductor region (30), thereby, in operation, storing volatile information in the form of electric charge or electric potential in said first semiconductor region (10) and transferring said information stored in said first semiconductor region (10) to said charge storing means (13) to store said information therein in non-volatile form before a power supply is perfectly turned off.

4. A semiconductor non-volatile random access memory as claimed in claim 3 and characterised by a third semiconductor region (20) in electrical contact with said first semiconductor region (10), a third insulated gate electrode (25) for controlling electric potential of said third semiconductor region (20), thereby, in operation, storing volatile information in the form of electric charge or electric potential in said third semiconductor region (20) and transferring said information stored in said third semiconductor region through the surface of said first semiconductor region (10) to said charge storing means (13) to store said information therein in a non-volatile form before the power supply is perfectly turned off.

5. A semiconductor non-volatile random access memory characterised by comprising a first semiconductor region (10), a first insulating film(s) (12) on said first semiconductor region, a charge storing means (13) provided in said insulating film(s), a first insulated gate electrode (15) electrically coupled to said charge storing means (13) and controlling the electric potential in said first semiconductor region (10) under said charge storing means, thereby, in operation, storing volatile information in the form of electric charge or electric potential in said first semiconductor region, and converting said volatile information into non-volatile form by applying a voltage to said first insulated gate electrode (15) before the power supply is perfectly turned off.

6. A semiconductor non-volatile random access memory as claimed in claim 5 characterised by a further semiconductor region (30) adjacent to said first semiconductor region (10), thereby, in operation, storing said volatile information in the form of electric charge or electric potential in said further semiconductor region (30) and converting said volatile information into a non-volatile form through said first semiconductor region (10) by applying voltage to said first insulated gate electrode (15) before the power supply is perfectly turned off.

7. A semiconductor non-volatile random access memory as claimed in claim 5 or 6 characterised by a second semiconductor region (20) electrically connected to said first semiconductor region (10), a second insulated gate electrode (25) controlling a channel (21) formed in said second semiconductor region, a read/write region (40) being electrically connected to said second semiconductor region (20).

8. A semiconductor non-volatile random access memory as claimed in any preceding claim characterised in that said charge storing means (13) is a floating gate.

9. A semiconductor non-volatile random access memory as claimed in any of claims 1 to 7 characterised in that said charge storing means (13) is formed by MNOS (Metal-Nitride-Oxide-Semiconductor) or MONOS (Metal-Oxide-Nitrode-Oxide-Semiconductor).

0259158

Fig.1.

Fig.2.

Fig.3.

## Fig.4.

## Fig.5.

## Fig.6.

0259158

## Fig.7.

## Fig.8.